# EUROPEAN PATENT APPLICATION

(11) **EP 2 068 361 A1**
(43) Date of publication of application: **10.06.2009**
(21) Application number: 07254688.0
(22) Date of filing: 04.12.2007
(51) Int. Cl.: H01L 23/538, H01L 23/498, H01L 23/16, H01L 21/58

(54) **Packaging substrate having chip embedded therein and manufacturing method thereof**

(71) Applicant: Phoenix Precision Technology Corporation, Hsin-Chu (TW)
(72) Inventor: Hsu, Shih-Ping, Hsinchu (TW); Lien, Chung-Cheng, Hsinchu (TW); Chen, Shang-Wei, Hsinchu (TW); Chia, Kang-Jung, Hsinchu (TW)
(74) Representative: Blatchford, William Michael

(57) **Abstract**

A packaging substrate (2) having a chip embedded therein, comprises a first aluminum substrate (21) having a first cavity therein; a second aluminum substrate (22) having a second cavity corresponding to the first cavity; a dielectric layer (23) disposed between the first aluminum substrate (21) and the second aluminum substrate (22); a chip (24) embedded in the first cavity and the second cavity, having an active surface (24a) with a plurality of electrode pads (241) thereon; and one built-up structure (2') disposed on the surface of the first aluminum substrate (21) and the active surface (24a) of the chip, wherein the built-up structure (2') has a plurality of conductive vias (272) electrically connecting to the electrode pads (241). The substrate warpage is obviously reduced by the assistance of using aluminum or aluminum alloy as the material of the substrate (2). Besides, a method of manufacturing a packaging substrate having a chip embedded therein is disclosed.

## Description

### BACKGROUND OF THE INVENTION

### 1. Field of the Invention

The present invention relates to a packaging substrate having a chip embedded therein and a manufacturing method thereof, which can prevent packaging substrate warpage caused by the asymmetric build-up.

### 2. Description of Related Art

With rigorous development of the electronic industry, the directions of the research in electronic products are turning to high integration and miniaturization to meet the needs for multi-function, high speed operation, and high frequency. Accordingly, the packaging substrate for connecting a plurality of active and non-active components to circuits is evolving from single layer to multi-layers in order to expand spaces of circuit layout to thereby meet the requirements of high wiring density for integrated circuits.

The conventional processes of electronic devices begin first by providing chip carriers suitable to semiconductor chips, such as substrates or lead frames, then the chip carriers are forwarded to semiconductor packaging manufacturers to proceed with the processes of chip disposing, molding, and ball mounting, etc; and finally, electronic devices having the required functions are produced.

A conventional semiconductor package structure is made such that a semiconductor chip is mounted by its back surface on the top surface of the substrate, then the package structure finished through wire bonding, or a semiconductor chip is mounted by the active surface thereof on the top surface of the substrate, thereby finishing a flip-chip package structure , followed by placing solder balls on the back of the substrate to provide electrical connections for a printed packaging substrate. Though high-number I/O connections are achieved in this way, usage on higher frequency and operations at higher speed are restricted due to limited performance of the package structure correspondingly because of lacks of shorter paths of leads.

Accordingly, considerable research has been invested in improvement of a packaging substrates with a chip embedded therein. The chip embedded in a packaging substrate can directly conduct to the electric devices outside, so as to shorten the electric conductive path, reduce the signal loss, protect the signal quality, and improve the ability of high-speed operation.

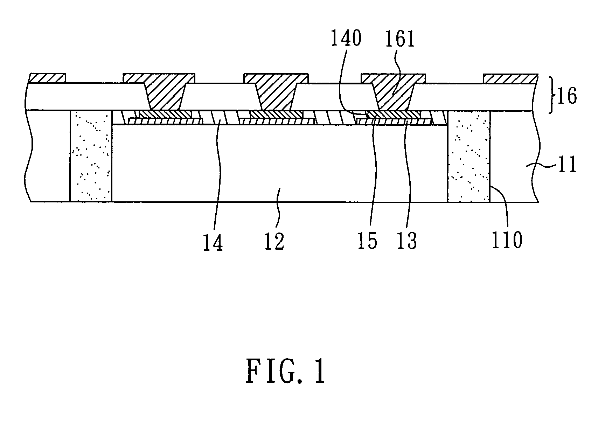

The conventional structure of a packaging substrate having a chip embedded therein is shown in FIG. 1. This packaging substrate comprises a substrate 11 having a cavity 110; a chip 12 disposed in the cavity 110, wherein the active surface of the chip 12 has a plurality of electrode pads 13 thereon; a protective layer 14 formed on the substrate 11 and having openings 140 to expose the electrode pads 13; a metal layer 15 formed on the electrode pads 13 each; and a built-up structure 16 formed on the substrate 11 and the chip 12. The built-up structure 16 has a plurality of conductive vias 161 electrically connecting to the electrode pads 13 of the chip 12.

So far, in the production, bismaleimide triazine (BT) resin is commonly used as the material of the substrate 11 having a chip 12 embedded therein. Unfortunately, as the built-up structure 16 is formed on one side of the substrate 11, substrate warpage occurs due to the unbalanced stresses from the surface having built-up structure thereon and the opposite surface having not built-up structure thereon. Accordingly, it is difficult to manufacture the packaging substrate, such that the yield is low, and the reliability is poor.

Therefore, using BT resin as the material of the substrate cannot meet the requirements of use because of the substrate warpage and low yield.

### SUMMARY OF THE INVENTION

In view of the aforementioned problems, the present invention provides a packaging substrate having a chip embedded therein, which comprises: a first aluminum substrate having a first cavity; a second aluminum substrate having a second cavity corresponding to the first cavity; a dielectric layer disposed between the first aluminum substrate and the second aluminum substrate; a chip embedded in the first cavity and the second cavity, having an active surface with a plurality of electrode pads thereon; and one built-up structure disposed on the surface of the first aluminum substrate and the active surface of the chip, wherein the built-up structure has a plurality of conductive vias electrically connecting to the electrode pads.

In the present invention, the substrate warpage is obviously reduced by the assistance of using aluminum or aluminum alloy as the material of the substrate.

In addition, an aluminum oxide layer can be selectively formed on the two surfaces of the first aluminum substrate as well as the second aluminum substrate. The aluminum oxide layers can be formed by any oxidation method, and anodic oxidation is preferred. The aluminum oxide/aluminum complex substrate formed through surface oxidation treatment has improved rigidity, thus further reduce the substrate warpage resulted from the asymmetric built-up structure.

In the present invention, the thicknesses of the first aluminum substrate and the second aluminum substrate are not limited. Preferably, the thickness of the first aluminum substrate, where the built-up structure is formed on, is smaller than that of the second aluminum substrate. Accordingly, after the built-up structure is formed, the packaging substrate is straightened due to the offset stresses from the build-up structure.

In the present invention, the chip can be fixed in the first cavity and the second cavity by using an adhesive material to fill the gap between the chip and the first cavity together with the second cavity, or by expressing through lamination the dielectric layer sandwiched between the first aluminum substrate and the second aluminum substrate to fill the gap between the chip and the first cavity together with the second cavity.

The present invention also provides a method of manufacturing a packaging substrate having a chip embedded therein, which comprises the following steps: (A) providing a first aluminum substrate and a second aluminum substrate; (B) forming a first cavity through the first aluminum substrate and correspondingly a second cavity through the second aluminum substrate; (C) disposing a dielectric layer between the first aluminum substrate and the second aluminum substrate; (D) embedding a chip in the first cavity and the second cavity, wherein the chip has an active surface with a plurality of electrode pads thereon, followed by lamination to combine the two substrates, and to express the dielectric layer to fill the gap between the chip and the first cavity together with the second cavity, to thereby fix the chip in the first cavity and the second cavity; and (E) forming one built-up structure on the surface of the first aluminum substrate and the active surface of the chip, wherein the built-up structure has at least one insulating layer, a circuit layer disposed on the insulating layer, and a plurality of conductive vias, parts of the conductive vias electrically connecting to the electrode pads of the chip.

In method of the present invention, the substrate warpage is obviously reduced by the assistance of using aluminum or aluminum alloy as the material of the substrate, and aluminum alloy is preferred. In addition, an aluminum oxide layer can be selectively formed on the two surfaces of the first aluminum substrate as well as the second aluminum substrate. The aluminum oxide layers can be formed by any oxidation method, and anodic oxidation is preferred. The aluminum oxide/aluminum complex substrate formed through surface oxidation treatment has improved rigidity, thus further reduce the substrate warpage resulted from the asymmetric built-up structure.

Furthermore, the present invention provides another method of manufacturing a packaging substrate having a chip embedded therein, which comprises the following steps: (A) providing a first aluminum substrate and a second aluminum substrate; (B) forming a dielectric layer between the first aluminum substrate and the second aluminum substrate by laminiation to form a complex aluminum substrate; (C) forming a cavity through the complex aluminum substrate; (D) embedding a chip in the cavity, wherein the chip has an active surface with a plurality of electrode pads thereon; and (E) forming one built-up structure on the surface of the first aluminum substrate and the active surface of the chip, wherein the built-up structure has at least one insulating layer, a circuit layer disposed on the insulating layer, and a plurality of conductive vias, parts of the conductive vias electrically connecting to the electrode pads of the chip.

In the method of the present invention, in step (D) an adhesive material fills the gap between the chip and the cavity to fix the chip in the cavity after the chip is embedded therein.

Related details about the above method can easily be known referring to those of the first method, thus not to be described further here.

Other objects, advantages, and novel features of the invention will become more apparent from the following detailed description when taken in conjunction with the accompanying drawings.

### BRIEF DESCRIPTION OF THE DRAWINGS

FIG. 1 is a cross-sectional view of a conventional structure of a packaging substrate having a chip embedded therein;
FIGS. 2a to 2e are cross-sectional views of the manufacturing method according to the first embodiment of the present invention;
FIGS. 3a to 3e are cross-sectional views of the manufacturing method according to the second embodiment of the present invention;
FIGS. 4a to 4e are cross-sectional views of the manufacturing method according to the third embodiment of the present invention; and
FIGS. 5a to 5e are cross-sectional views of the manufacturing method according to the fourth embodiment of the present invention.

### DETAILED DESCRIPTION OF THE PREFERRED EMBODIMENT

### Embodiment 1

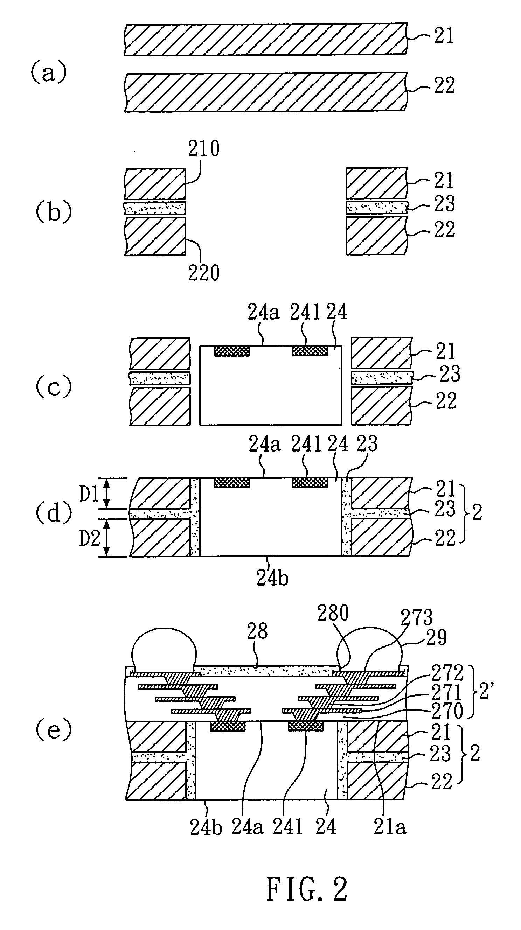

With reference to FIGS. 2a to 2e, a cross-sectional view of the manufacturing method of the packaging substrate having a chip embedded therein is shown in this embodiment.

As shown in FIG. 2a, a first aluminum substrate 21 and a second aluminum substrate 22 are first provided. Next, as shown in FIG. 2b, a first cavity 210 is formed through the first aluminum substrate 21, and correspondingly a second cavity 220 is formed through the second aluminum substrate 22. Then, a dielectric layer 23 is disposed between the first aluminum substrate 21 and the second aluminum substrate 22. As shown in FIG. 2c, a chip 24 is embedded in the first cavity 210 and the second cavity 220, followed by lamination to combine the two substrates 21,22, and to express the dielectric layer 23 to fill the gap between the chip 24 and the cavities 210,220, to thereby fix the chip 24 in the cavities 210,220, as shown in FIG. 2d. The chip 24 has a plurality of electrode pads 241 on its active surface 24a, while the non-active surface 24b of the chip 24 is exposed to provide a good heat dispersal area.

After the above steps are completed, a built-up structure 2' is formed on the upper surface 21 a of the first aluminum substrate 21 and the active surface 24a of the chip 24, as shown in FIG. 2e, wherein the built-up structure has at least one insulating layer 270, a circuit layer 271 disposed on the insulating layer 270, and a plurality of conductive vias 272, parts of the conductive vias 272 electrically connecting to the electrode pads 241 of the chip 24. The method of forming the built-up structure 2' is well known in the art, thus not to be described further here.

In addition, a solder mask layer 28 is formed on the surface of the built-up structure 2', having openings 280 to expose the conductive pads 273 of the built-up structure 2'. Finally, solder bumps 29 are formed on the conductive pads 273. Thus, the packaging substrate having a chip embedded therein of this embodiment is completed.

In this embodiment, the thickness (D1) of the first aluminum substrate 21 is smaller that the thickness (D2) of the second aluminum substrate 22, as shown in FIG. 2d . Accordingly, after the built-up structure 2' is formed, the packaging substrate is straightened due to the offset stresses from the build-up structure 2'.

### Embodiment 2

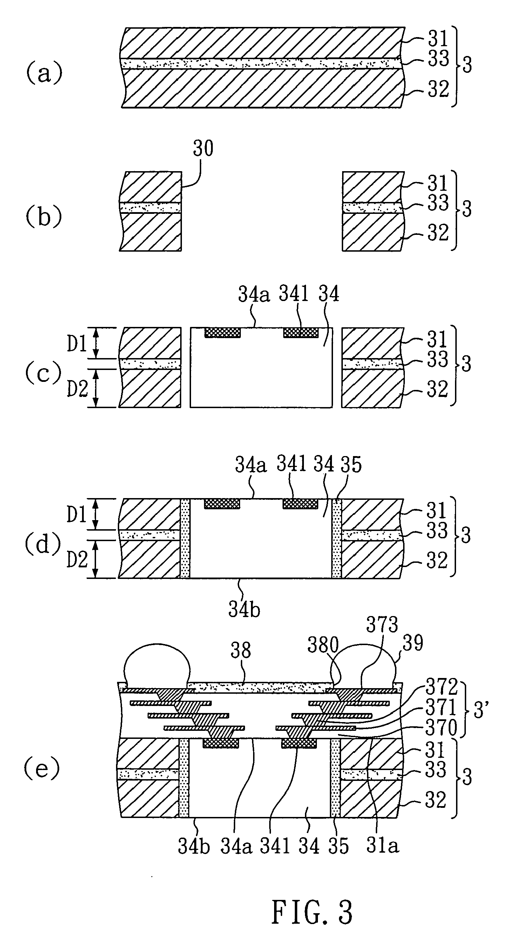

With reference to FIGS. 3a to 3e, a cross-sectional view of the manufacturing method of the packaging substrate having a chip embedded therein is shown in this embodiment.

As shown in FIG. 3a, a first aluminum substrate 31 and a second aluminum substrate 32 are first provided. Next, a dielectric layer 33 is formed between the first aluminum substrate 31 and the second aluminum substrate 32 by lamination to form a complex aluminum substrate 3.

Subsequently, a cavity 30 is formed through the complex aluminum substrate 3, as shown in FIG. 3b. Next, a chip 34 is embedded in the cavity 30 of the complex aluminum substrate 3, as shown in FIG. 3c. Then, an adhesive material 35 fills the gap between the chip 34 and the cavity 30 to fix the chip 34, as shown in FIG. 3d. In this embodiment, the adhesive material 35 is epoxy resin. The chip 34 has a plurality of electrode pads 341 on its active surface 34a, while the non-active surface 34b of the chip 34 is exposed to provide a good heat-dispersal area.

After the above steps are completed, a built-up structure 3' is formed on the upper surface 31 a of the first aluminum substrate 31 and the active surface 34a of the chip 34, as shown in FIG. 3e, wherein the built-up structure 3' has at least one insulating layer 370, a circuit layer 371 disposed on the insulating layer 370, and a plurality of conductive vias 372, parts of the conductive vias 372 electrically connecting to the electrode pads 341 of the chip 34. The method of forming the built-up structure 3' is well known in the art, thus not to be described further here.

In addition, a solder mask layer 38 is formed on the surface of the built-up structure 3', having openings 380 to expose the conductive pads 373 of the built-up structure 3'. Finally, solder bumps 39 are formed on the conductive pads 373. Thus, the packaging substrate having the chip embedded therein of this embodiment is completed.

In addition, the thickness (D1) of the first aluminum substrate 31 is smaller that the thickness (D2) of the second aluminum substrate 32, as shown in FIG. 3d. Accordingly, after the built-up structure 3' is formed, the packaging substrate is straightened due to the offset stresses from the build-up structure 3'(see FIG. 2e).

### Embodiment 3

The method for manufacturing a packaging substrate having a chip embedded therein of this embodiment is similar to Embodiment 1. Except the two surfaces of the first aluminum substrate and the second aluminum substrate being oxidized to form aluminum oxide layers respectively, all other aspects are approximately the same as those of the Embodiment 1.

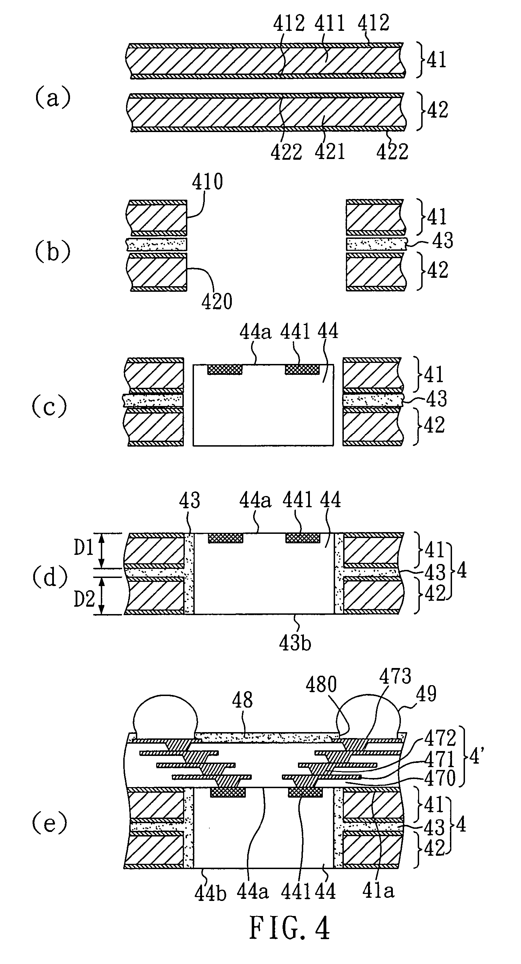

With reference to FIGS. 4a to 4e, cross-sectional views of the manufacturing method of the packaging substrate having a chip embedded therein in this embodiment are shown.

As shown in FIG. 4a, a first aluminum substrate 41 and a second aluminum substrate 42 are first provided. The first aluminum substrate 41 and the second aluminum substrate 42 are put into an electrolytic tank for oxidization. The two surfaces of the first aluminum substrate 41 and the second aluminum substrate 42 are oxidized to become aluminum oxide layers 412,422 respectively. Spontaneously, an aluminum layer 411,421 is sandwiched between two aluminum oxide layers 412,422. In the present embodiment, the first aluminum substrate 41 and the second aluminum substrate 42 are put into an electrolytic tank for anodic oxidation. Through controlling the duration of anodic oxidation, the width of the aluminum oxide layers 412,422 is decided.

Referring to FIGS. 4b to 4e, the following process can be known from the first embodiment corresponding to FIGS. 2b to 2e, thus not to be described further here.

The rigidity of the first aluminum substrate 41 and the second aluminum substrate 42 is further improved by forming aluminum oxide layers 412,422 (i.e. ceramic material) through oxidation. Accordingly, the packaging substrate of this embodiment remains straight having a built up structure 4' on one side thereof.

### Embodiment 4

The method for manufacturing a packaging substrate having a chip embedded therein of this embodiment is similar to Embodiment 2. Except the two surfaces of the first aluminum substrate and the second aluminum substrate being oxidized to form aluminum oxide layers respectively, all other aspects are approximately the same as those of the Embodiment 2.

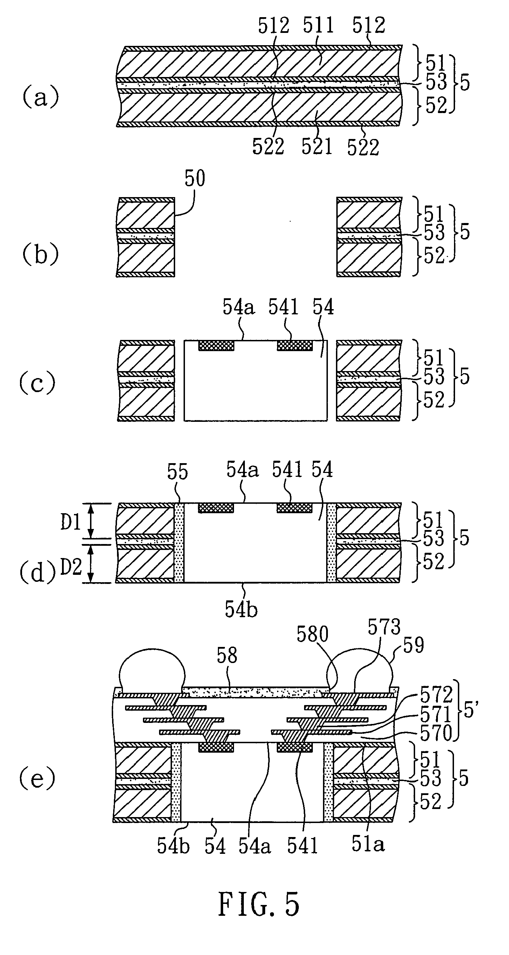

With reference to FIGS. 5a to 5e, cross-sectional views of the manufacturing method of the packaging substrate having a chip embedded therein in this embodiment are shown.

As shown in FIG. 5a, a first aluminum substrate 51 and a second aluminum substrate 52 are first provided. The first aluminum substrate 51 and the second aluminum substrate 52 are put into an electrolytic tank for oxidization. The two surfaces of the first aluminum substrate 51 and the second aluminum substrate 52 are oxidized to become aluminum oxide layers 512,522 respectively. Spontaneously, an aluminum layer 511,521 is sandwiched between two aluminum oxide layers 512,522. In the present embodiment, the first aluminum substrate 51 and the second aluminum substrate 52 are put into an electrolytic tank for anodic oxidation. Through controlling the duration of anodic oxidation, the width of the aluminum oxide layers 512,522 is decided.

Referring to FIGS. 5b to 5c, the following process can be known from the first embodiment corresponding to FIGS. 3b to 3e, thus not to be described further here.

The rigidity of the first aluminum substrate 51 and the second aluminum substrate 52 is further improved by forming aluminum oxide layers 512,522 (i.e. ceramic material) through oxidation. Accordingly, the packaging substrate of this embodiment remains straight having a built up structure 5' on one side thereof.

Although the present invention has been explained in relation to its preferred embodiment, it is to be understood that many other possible modifications and variations can be made without departing from the scope of the invention as hereinafter claimed.

## Claims

1. A packaging substrate having a chip embedded therein, comprising:
a first aluminum substrate having a first cavity;
a second aluminum substrate having a second cavity corresponding to the first cavity;
a dielectric layer disposed between the first aluminum substrate and the second aluminum substrate;
a chip embedded in the first cavity and the second cavity, having an active surface with a plurality of electrode pads thereon; and
one built-up structure disposed on the surface of the first aluminum substrate and the active surface of the chip, wherein the built-up structure has a plurality of conductive vias electrically connecting to the electrode pads.

2. The packaging substrate as claimed in claim 1, wherein the material of the first aluminum substrate and the second aluminum substrate is aluminum or aluminum alloy.

3. The packaging substrate as claimed in claim 1, wherein the thickness of the first aluminum substrate is smaller than that of the second aluminum substrate.

4. The packaging substrate as claimed in claim 1, wherein a aluminum oxide layer is formed on each of the two surfaces of the first aluminum substrate, as well as the second aluminum substrate.

5. The packaging substrate as claimed in claim 1, wherein an adhesive material fills the gap between the first cavity and the chip, together with the gap between the second cavity and the chip, to thereby fix the chip in the first cavity and the second cavity.

6. The packaging substrate as claimed in claim 1, wherein a dielectric layer is disposed between the first aluminum substrate and the second aluminum substrate, also filling the gap between the first cavity and the chip, together with the gap between the second cavity and the chip, to thereby fix the chip in the first cavity and the second cavity.

7. The packaging substrate as claimed in claim 1, wherein the built-up structure comprises at least one insulating layer, a circuit layer disposed on the insulating layer, and a plurality of conductive vias, wherein parts of the conductive vias electrically connects to the electrode pads of the chip.

8. A method of manufacturing a packaging substrate having a chip embedded therein, comprising the following steps:
(A) providing a first aluminum substrate and a second aluminum substrate;
(B) forming a first cavity through the first aluminum substrate and correspondingly a second cavity through the second aluminum substrate;
(C) disposing a dielectric layer between the first aluminum substrate and the second aluminum substrate;
(D) embedding a chip in the first cavity and the second cavity, wherein the chip has an active surface with a plurality of electrode pads thereon, followed by lamination to combine the two substrates, and to express the dielectric layer to fill the gap between the chip and the first cavity together with the second cavity, to thereby fix the chip in the first cavity and the second cavity; and
(E) forming one built-up structure on the surface of the first aluminum substrate and the active surface of the chip, wherein the built-up structure has at least one insulating layer, a circuit layer disposed on the insulating layer, and a plurality of conductive vias, parts of the conductive vias electrically connecting to the electrode pads of the chip.

9. The method as claimed in claim 8, wherein in step (A) a aluminum oxide layer is formed on each of the two surfaces of the first aluminum substrate, as well as the second aluminum substrate.

10. The method as claimed in claim 9, wherein the aluminum oxide layers are formed by anodic oxidation.

11. A method of manufacturing a packaging substrate having a chip embedded therein, comprising the following steps:
(A) providing a first aluminum substrate and a second aluminum substrate;
(B) forming a dielectric layer between the first aluminum substrate and the second aluminum substrate by lamination to form a complex aluminum substrate;
(C) forming a cavity through the complex aluminum substrate;
(D) embedding a chip in the cavity, wherein the chip has an active surface with a plurality of electrode pads thereon; and
(E) forming one built-up structure on the surface of the first aluminum substrate and the active surface of the chip, wherein the built-up structure has at least one insulating layer, a circuit layer disposed on the insulating layer, and a plurality of conductive vias, parts of the conductive vias electrically connecting to the electrode pads of the chip.

12. The method as claimed in claim 11, wherein in step (D) an adhesive material fills the gap between the chip and the cavity to fix the chip in the cavity after the chip is embedded therein.

13. The method as claimed in claim 11, wherein in step (A) a aluminum oxide layer is formed on each of the two surfaces of the first aluminum substrate, as well as the second aluminum substrate.

14. The method as claimed in claim 11, wherein the aluminum oxide layers are formed by anodic oxidation.
